(19) Europäisches Patentamt / European Patent Office / Office européen des brevets

(11) **EP 4 411 405 B1**

(12) **EUROPEAN PATENT SPECIFICATION**

(45) Date of publication and mention
of the grant of the patent:
**05.08.2026 Bulletin 2026/32**

(21) Application number: **22945218.0**

(22) Date of filing: **08.06.2022**

(51) International Patent Classification (IPC):
*H10N 30/30* (2023.01)      *G01R 33/10* (2006.01)
*G01L 1/16* (2006.01)      *H04R 1/08* (2006.01)
*G01B 7/06* (2006.01)

(52) Cooperative Patent Classification (CPC):
**H10N 30/302; G01H 11/08; G01L 1/16;**
**H04R 17/02; H10N 30/101;** H10N 30/50

(86) International application number:
**PCT/CN2022/097541**

(87) International publication number:
**WO 2023/236072 (14.12.2023 Gazette 2023/50)**

(54) **SENSOR**

MESSFÜHLER

CAPTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.08.2024 Bulletin 2024/32**

(73) Proprietor: **Shenzhen Shokz Co., Ltd.
Shenzhen, Guangdong 518108 (CN)**

(72) Inventors:
• **YUAN, Yongshuai
Shenzhen, Guangdong 518108 (CN)**

• **LIAO, Fengyun
Shenzhen, Guangdong 518108 (CN)**
• **QI, Xin
Shenzhen, Guangdong 518108 (CN)**

(74) Representative: **Huang, Liwei
Cäcilienstraße 12
40597 Düsseldorf (DE)**

(56) References cited:
**EP-A2- 2 109 217      CN-A- 101 765 046
CN-A- 111 965 572      CN-A- 112 816 109
JP-A- 2003 284 182      KR-A- 20130 134 196
US-A1- 2015 358 740**

## Description

## TECHNICAL FIELD

The present invention relates to the field of acoustic technology and, in particular, to a sensor.

## BACKGROUND

Sensors can be widely used in micro-electro-mechanical systems (MEMS) such as accelerometers, speakers, gyroscopes, energy harvesters, bone conduction microphones, or other devices.

However, the intrinsic resonance frequencies and sensitivities of current sensors are often fixed when the devices are fabricated, making it difficult to adapt to complex and changing practical application scenarios. For example, there is a need to utilize energy harvesters with different resonance frequencies in order to harvest energy in different frequency bands. As another example, sensors need to reduce their sensitivity for self-protection under suddenly enhanced external excitation.

Accordingly, there is a need to propose a sensor with an adjustable resonance frequency and adjustable sensitivity.

Some sensors in prior arts can be seen in US 20150358740A1 and EP 2109217A2.

## SUMMARY

The invention is set out in the appended set of claims.

In some embodiments, the frequency adjustment assembly deforms the sensing piezoelectric layer in a first direction.

In some embodiments, the sensing piezoelectric layer is a rectangle and the first direction is in a length direction of the sensing piezoelectric layer.

In some embodiments, the sensor is fixedly supported at both ends or peripherally supported.

In some embodiments, the sensing piezoelectric layer is a circle and the first direction is in a radial direction of the sensing piezoelectric layer.

In some embodiments, the sensor is peripherally supported.

In some embodiments, the frequency adjustment assembly includes a drive piezoelectric layer and a drive electrode layer.

In some embodiments, the sensing piezoelectric layer and the drive piezoelectric layer are in a same plane.

In some embodiments, the drive piezoelectric layer is in a middle of the sensing piezoelectric layer.

In some embodiments, a length of the drive piezoelectric layer is in a range of 100%-500% of a length of the sensing piezoelectric layer.

In some embodiments, sensing electrodes are distributed within 1/4 of a total length on the sensing piezoelectric layer near a fixedly supported end, the total length is a sum of a length of the sensing piezoelectric layer and a length of the drive piezoelectric layer along a first direction.

In some embodiments, the drive piezoelectric layer is at a position near a fixedly supported end of the sensing piezoelectric layer.

In some embodiments, a voltage of the drive electrode layer drives the drive piezoelectric layer to contract.

In some embodiments, the sensing piezoelectric layer is connected to the drive electrode layer by a mortise and tenon structure.

In some embodiments, the sensing piezoelectric layer and the drive piezoelectric layer are an integral structure made of a same material, and that the sensing assembly and the frequency adjustment assembly are formed respectively after arranging the sensing electrode layer and the drive electrode layer in different regions on a surface of the integral structure.

In some embodiments, a deformation of the sensing piezoelectric layer caused by the frequency adjustment assembly is a tensile deformation.

In some embodiments, the substrate is a quadrilateral cavity.

In some embodiments, a size of the quadrilateral cavity is in a range from 1.0mm x 1.0mm -2.5mm x 2.5mm.

In some embodiments, the sensing piezoelectric layer includes at least a first sensing piezoelectric layer and a second sensing piezoelectric layer, and the drive piezoelectric layer is located between the first sensing piezoelectric layer and the second sensing piezoelectric layer.

In some embodiments, the first sensing piezoelectric layer is stacked on the drive piezoelectric layer and the drive piezoelectric layer is stacked on the second sensing piezoelectric layer.

In some embodiments, the first sensing piezoelectric layer, the drive piezoelectric layer, and the second sensing piezoelectric layer are disposed parallel and at intervals from each other, and an end of the first sensing piezoelectric layer, an end of the drive piezoelectric layer, and an end of the second sensing piezoelectric layer are connected by a connection assembly.

Embodiments of the present invention can be used to realize the sensitivity adjustment of the sensor by setting the frequency adjustment assembly, changing the voltage applied to the frequency adjustment assembly to deform the frequency adjustment assembly to drive the sensing piezoelectric layer to deform, and changing the value of the stress and the value of the strain within the structure of the sensing piezoelectric layer, so as to adjust the resonance frequency of the sensing assembly.

## BRIEF DESCRIPTION OF THE DRAWINGS

This description will be further explained in the form of exemplary embodiments, which will be described in detail by means of accompanying drawings. These embodiments are not restrictive, in which the same numbering indicates the same structure, where:

FIG. 1 is a block diagram illustrating a structure of an exemplary sensor according to some embodiments of the present invention;

FIG. 2A is a top view illustrating an exemplary sensor according to some embodiments of the present invention;

FIG. 2B is a front view illustrating an exemplary sensor according to some embodiments of the present invention;

FIG. 2C is a side view illustrating an exemplary sensor according to some embodiments of the present invention;

FIG. 3A is a schematic diagram illustrating a three-dimensional structure of the exemplary sensor according to some embodiments of the present invention;

FIG. 3B is a schematic diagram illustrating a front view structure of an exemplary sensor according to some embodiments of the present invention;

FIG. 4A is a schematic diagram illustrating an exemplary sensor according to some embodiments of the present invention;

FIG. 4B is a schematic diagram illustrating an exemplary sensor according to some embodiments of the present invention;

FIG. 5 is a schematic diagram illustrating a relationship between a resonance frequency and a voltage of an exemplary sensor according to some embodiments of the present invention; and

FIG. 6 is a schematic diagram illustrating a frequency response curve of an exemplary sensor according to some embodiments of the present invention.

## DETAILED DESCRIPTION

In the following detailed description, numerous specific details are set forth by way of examples in order to provide a thorough understanding of the relevant disclosure. Obviously, drawings described below are only some examples or embodiments of the present invention. Those skilled in the art, without further creative efforts, may apply the present invention to other similar scenarios according to these drawings. Unless obviously obtained from the context or the context illustrates otherwise, the same numeral in the drawings refers to the same structure or operation.

It will be understood that the terms "system," "device," "unit," and/or "module" used herein are one method to distinguish different components, elements, parts, sections, or assemblies of different levels. However, the terms may be displaced by another expression if they achieve the same purpose.

As shown in the present invention and claims, unless the context clearly prompts the exception, "a," "one," and/or "the" is not specifically singular, and the plural may be included. It will be further understood that the terms "comprise," "comprises," and/or "comprising," "include," "includes," and/or "including," when used in present invention, specify the presence of stated features, integers, steps, operations, elements, and/or components, but do not preclude the presence or addition of one or more other features, integers, steps, operations, elements, components, and/or groups thereof.

The flowcharts used in the present invention illustrate operations that systems implement according to some embodiments of the present invention. It is to be expressly understood the operations of the flowcharts may be implemented not in order. Conversely, the operations may be implemented in an inverted order, or simultaneously. Moreover, one or more other operations may be added to the flowcharts. One or more operations may be removed from the flowcharts.

Embodiments of the present invention describe a sensor. The sensor may include: a sensing assembly, a frequency adjustment assembly, and a substrate. The substrate is configured carry the sensing assembly and the frequency adjustment assembly. The sensing assembly may include a sensing piezoelectric layer and a sensing electrode layer. The frequency adjustment assembly may be physically connected to the sensing assembly, and the frequency adjustment assembly deforms under the action of an electrical signal to deform the sensing piezoelectric layer, thereby changing a resonance frequency of the sensing assembly.

Embodiments of the present invention may realize a sensitivity adjustment of the sensor by providing the frequency adjusting assembly, changing a voltage applied to the frequency adjusting assembly to deform the frequency adjustment assembly to drive a deformation of the sensing piezoelectric layer to change a stress value and a strain value (hereinafter referred to as the stress) within the structure of the sensing piezoelectric layer, and thereby adjusting a resonance frequency of the sensing assembly.

The following describes an intrinsic frequency as an example of a string tensioned at both ends, a fixedly supported beam at both ends, and a peripherally supported film. As the string tensioned at both ends (also referred to as, a linear elastic member) undergoes free vibration, there exists a correspondence between its intrinsic resonance frequency and a physical parameter of the string (e.g., a string length, a string tension, and a linear density of the string). In some embodiments, the resonance frequency of the string has the following correspondence with the string length, the string tension, and the linear density of the string:

$$f = \frac{1}{2L}\sqrt{\frac{T}{\rho}} \quad (1)$$

where, is the resonance frequency of the string, is the string length, is the string tension, and is the line density of the string. In some embodiments, since there is a correspondence between the resonance frequency and the string tension of the string, the resonance frequency of the string may be adjusted by way of adjusting a magnitude of the string tension.

Similar to the string, there is a correspondence between the resonance frequency of the sensing assembly and a physical parameter of the sensing assembly. In some embodiments, the sensing assembly may be any assembly that generates an electrical signal in response to deformation. For example, the sensing assembly may be a piezoelectric sensing assembly, where the piezoelectric sensing assembly generates an electrical signal in response to external vibration. Exemplary sensing assemblies may include, for example, a cantilever beam, a beam that is fixedly supported at both ends (e.g., a piezoelectric beam), or a diaphragm that is fixedly supported at the periphery (e.g., a piezoelectric membrane). As another example, the sensing assembly may be a capacitive sensing assembly, where the capacitive sensing assembly receives deformation resulting in a change in a distance between electrode plates thereon and generates an electrical signal. The piezoelectric sensing assembly is described below as an example. For example, a resonance frequency of the cantilever beam or the diaphragm may have a correspondence with its own physical parameters. Exemplarily, the resonance frequency of the diaphragm may have the following correspondence with a radius of the diaphragm, a membrane tension, and a surface density of the diaphragm:

$$f_m = \frac{2.405}{2\pi a} \sqrt{\frac{T_m}{\rho_m}} \quad (2)$$

where, is the resonance frequency of the diaphragm, is the radius of the diaphragm, is the membrane tension, and is the surface density of the diaphragm. In some embodiments, since there exists a correspondence between the resonance frequency of the diaphragm and the membrane tension, the resonance frequency of the diaphragm may be adjusted by way of adjusting a magnitude of the membrane tension.

In some embodiments, the frequency adjustment assembly may include a piezoelectric material. The piezoelectric material has a piezoelectric effect, which means that the piezoelectric material deforms when the piezoelectric material receives an external vibration signal, thereby outputting an electrical signal. Exemplarily, the piezoelectric effect of the piezoelectric material may be represented as:

$$D_i = d_{ij} T_j + \varepsilon_{ij}^T E_j \quad (3)$$

where is the electric displacement of the piezoelectric material, is the piezoelectric strain coefficient, is the stress, is the dielectric constant under a constant force, and is the electric field strength. In some embodiments, a magnitude of an electrical signal output by the piezoelectric material (i.e., the electric displacement) is related to the electric field strength (i.e., the voltage) applied to the piezoelectric material.

In some embodiments, the piezoelectric material also has an inverse piezoelectric effect, i.e., applying an electrical signal to the piezoelectric material causes the piezoelectric material to deform mechanically. Exemplarily, the inverse piezoelectric effect of the piezoelectric material may be represented as:

$$S_k = d_{jk}^T E_j + s_{kl}^E T_l \quad (4)$$

where is the displacement of the piezoelectric material, is the piezoelectric strain factor, is the electric field strength, is the elastic flexibility factor, and is the stress. In some embodiments, a deformation (i.e., the displacement) of the piezoelectric material is related to the electric field strength (i.e., voltage) applied to the piezoelectric material.

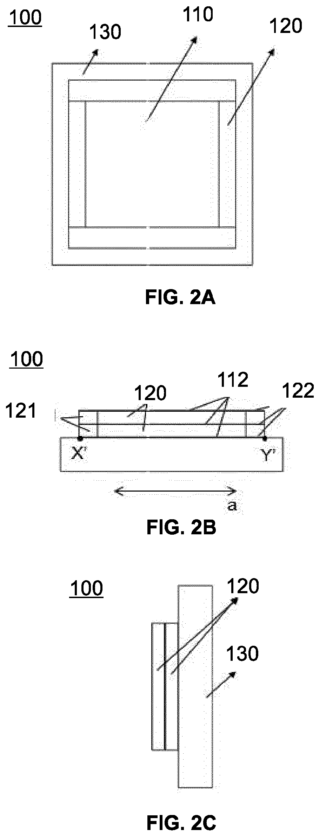

According to Equation (2) and Equation (3), the piezoelectric material in the frequency adjustment assembly may deform under the action of the electrical signal, further deforming the sensing assembly connected to the frequency adjustment assembly, changing the stress in the sensing assembly, and thereby changing the resonance frequency of the sensing assembly. In some embodiments, the frequency adjustment assembly may further include other materials capable of deformation in response to the electrical signal, such as a thermoelectric material, an electromagnetic material, an electrostatic material, or the like. Exemplarily, thermal energy may be adjusted by varying the magnitude of the electrical signal, causing a temperature of the thermoelectric material to change and thus the thermoelectric material to deform. As another example, changing the electrical signal may cause an electromagnetic force applied to the electromagnetic material to change thereby causing the electromagnetic material to deform. As another example, the electrostatic force may be changed in such a way as to adjust a contact distance between the electrode plates on both sides of the electrostatic material. For more information on the frequency adjustment assembly, please refer to other parts of the present invention, such as FIG. 2A-FIG. 2C, FIG.3A-FIG. 3B, FIG. 4A-FIG. 4B, and their descriptions.

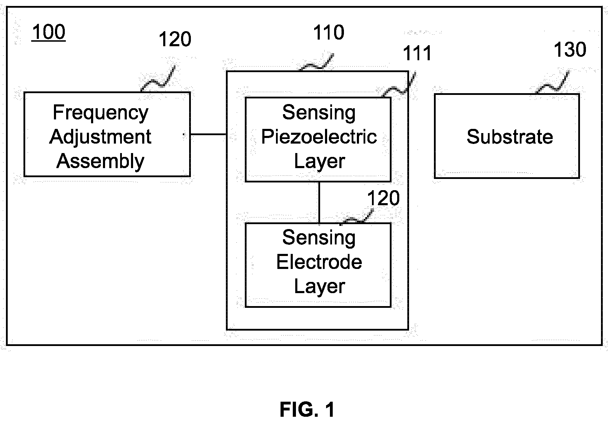

FIG. 1 is a block diagram illustrating a structure of an exemplary sensor 100 according to some embodiments of the present invention. As shown in FIG. 1, the sensor 100 may include: a sensing assembly 110, a frequency adjustment assembly 120, and a substrate 130.

The sensing assembly 110 may be configured as a component having a piezoelectric effect or an inverse piezoelectric effect. In some embodiments, the sensing assembly 110 may be configured to generate a vibration based on an electrical signal. For example, when an electrical signal is applied to the sensing assembly 110, the sensing assembly 110 may reciprocally deform in response to the electrical signal thereby generating a vibration. In some embodiments, the sensing assembly 110 may also deform in response to an external vibration signal and generate an electrical signal based on the deformation. For example, the sensing assembly 110 may be in contact with the substrate 130, thereby deforming in response to the vibration of the substrate 110, thereby generating an electrical signal. As another example, the sensing assembly 110 may deform under the drive of the deformation of the frequency adjustment assembly 120, thereby generating an electrical signal.

In some embodiments, the sensing assembly 110 may include a sensing piezoelectric layer 111 and a sensing electrode layer 112. In some embodiments, the sensing electrode layer 112 may cover at least one surface of the sensing piezoelectric layer 111. The sensing piezoelectric layer 111 may be configured as a component that provides a piezoelectric effect and/or an inverse piezoelectric effect. In some embodiments, the sensing piezoelectric layer 111 may be a structure capable of vibrating in response to a drive voltage, and the sensing electrode layer 112 provides the drive voltage to the sensing piezoelectric layer 111. In some embodiments, the sensing piezoelectric layer 111 may also be a structure that deforms when subjected to an external force (e.g., a vibration of a vibration component) and generates an electrical signal based on the deformation, and the sensing electrode layer 112 is configured transmit the electrical signal.

In some embodiments, the sensing piezoelectric layer 111 may be a piezoelectric polymer film obtained by a deposition process for semiconductors (e.g., magnetron sputtering, MOCVD). In some embodiments, the material of the sensing piezoelectric layer 111 may include a piezoelectric crystal material and a piezoelectric ceramic material. In some embodiments, the piezoelectric crystal may refer to a piezoelectric single crystal. Exemplary piezoelectric crystal materials may include crystals, sphalerite, galena, tourmaline, rhodochrosite, GaAs, barium titanate and its derived structural crystals, KH2PO4, NaKC4H4O6-4H2O (rosette salt), etc., or any combination thereof. In some embodiments, the piezoelectric ceramic material refers to a piezoelectric polycrystal consisting of an irregular collection of microscopic grains obtained by solid-phase reaction and sintering between powder grains of different materials. Exemplary piezoelectric ceramic materials may include barium titanate (BT), lead zirconate titanate (PZT), lead barium lithium niobate (PBLN), modified lead titanate (PT), aluminum nitride (AlN), zinc oxide (ZnO), etc., or any combination thereof. In some embodiments, the material of the piezoelectric layer 410 may also be a piezoelectric polymer material. Exemplary piezoelectric polymer materials may include polyvinylidene fluoride (PVDF) etc.

In some embodiments, a thickness of the sensing piezoelectric layer 111 may be in a range of 0.5 $\mu$m-10 $\mu$m. In some embodiments, the thickness of the sensing piezoelectric layer 111 may be in a range of 0.5 $\mu$m-5 $\mu$m. In some embodiments, the thickness of the sensing piezoelectric layer 111 may be in a range of 0.5 $\mu$m-2 $\mu$m. In some embodiments, the thickness of the sensing piezoelectric layer 111 may be different for different materials. For example, the material of the sensing piezoelectric layer 111 may include PZT, AlN, ZnO, or PVDF, and the thickness of the sensing piezoelectric layer 111 is in a range of 0.5 $\mu$m-5 $\mu$m. As another example, the material of the sensing piezoelectric layer 111 may include PZT, and the thickness of the sensing piezoelectric layer 111 is in a range of 0.5 $\mu$m-2 $\mu$m. As another example, the material of the sensing piezoelectric layer 111 may include PVDF, and the thickness of the sensing piezoelectric layer 111 is in a range of 1 $\mu$m-5 $\mu$m.

In some embodiments, the sensing piezoelectric layer 111 may have a single layer structure. The sensing piezoelectric layer 111 may be bent to varying degrees based on the magnitude of the vibration to output a corresponding voltage. In some embodiments, the sensing piezoelectric layer 111 may also have a multilayer structure to increase a range of regulation of the stress of the sensing piezoelectric layer 111. The at least two sensing piezoelectric layers 111 may be provided using a layer stack. For example, a plurality of sensing piezoelectric layers 111 may be provided in a stack along a thickness direction of the sensing piezoelectric layer 111.

In some embodiments, the resonance frequency of the sensing piezoelectric layer 111 may have a correspondence with a physical parameter of the sensing piezoelectric layer 111 (e.g., including a stress), and thus, the resonance frequency of the sensing assembly 110 may be adjusted through changing the stress of the sensing piezoelectric layer 111. Exemplarily, according to the above equation (2), increasing the stress (e.g., the membrane tension $T_m$) of the sensing piezoelectric layer 111 may increase the resonance frequency (e.g., the resonance frequency $f_m$) of the sensing assembly 110, and conversely, decreasing the stress of the sensing piezoelectric layer 111 may decrease the resonance frequency of the sensing assembly 110. In some embodiments, the stress of the sensing piezoelectric layer 111 may include a tensile stress and a compressive stress. The tensile stress may be a stress generated when there is a tendency for the sensing piezoelectric layer 111 to contract (i.e., when it is stretched), and the compressive stress may be a stress generated when there is a tendency for the sensing piezoelectric layer 111 to elongate (i.e., when it is compressed). For more information on the sensing piezoelectric layer 111, please refer to other parts of the present invention, such as FIG. 2A-FIG. 2C, FIG. 3A-FIG. 3B, FIG. 4A-FIG. 4B, and their descriptions.

The sensing electrode layer 112 may be configured as a component that transmits an electrical signal. For example, the sensing electrode layer 112 may provide a drive voltage to the sensing piezoelectric layer 111 to cause the sensing piezoelectric layer 111 to vibrate. As another example, the sensing electrode layer 112 may also capture an electrical signal generated when the sensing piezoelectric layer 111 deforms. In some embodiments, the material of the sensing electrode layer 112 may include copper (Cu), platinum (Pt), molybdenum (Mo), titanium (Ti), or any combination thereof. In some embodiments, the thickness of the sensing electrode layer 112 may be in a range of 0.1 $\mu$m-2 $\mu$m. For example, the material of the sensing electrode layer 112 may include a Pt/Ti composite metal, and the thickness of the sensing electrode layer may be in a range of 0.1 $\mu$m-0.5 $\mu$m.

In some embodiments, the sensing electrode layer 112 may be provided on at least one surface of the sensing piezoelectric layer 111. In some embodiments, the sensing electrode layer 112 is provided on two opposite surfaces of the sensing piezoelectric layer 111, respectively. In some embodiments, the sensing electrode layer 112 may also be provided between two adjacent sensing piezoelectric layers 111 in the plurality of sensing piezoelectric layers 111 to capture electrical signals generated by the two adjacent sensing piezoelectric layers 111. In some embodiments, the sensing electrode layer 112 may be provided on a surface of the sensing piezoelectric layer 111 by one or more affixing methods, such as deposition, coating, inlay, fit, etc.

The frequency adjustment assembly 120 may be configured as an assembly that adjusts the resonance frequency of the sensing assembly 110. For example, the frequency adjustment assembly 120 may be physically connected to the sensing assembly 110 such that when the frequency adjustment assembly 120 deforms in response to an electrical signal, the sensing piezoelectric layer 111 of the sensing assembly 110 deforms accordingly, thereby changing the resonance frequency of the sensing assembly 110. In some embodiments, changing the magnitude of the electrical signal applied to the frequency adjusting assembly 120 may change a deformation degree of the frequency adjusting assembly 120, thereby adjusting a deformation degree of the sensing piezoelectric layer 111 and a magnitude of the stress on the sensing piezoelectric layer 111, thereby adjusting the resonance frequency of the sensing assembly 110. Exemplarily, when the frequency adjustment assembly 120 deforms under the action of the electrical signal and produces a tensile stress on the sensing assembly 110, increasing the magnitude of the electrical signal increases the deformation of the frequency adjustment assembly 120, increases the deformation degree of the sensing piezoelectric layer 111 and increases the tensile stress, and thereby increasing the resonance frequency of the sensing assembly 110. Conversely, reducing the magnitude of the electrical signal reduces the deformation of the frequency adjustment assembly 120, reduces the deformation degree of the sensing piezoelectric layer 111, and reduces the tensile stress, thereby reducing the resonance frequency of the sensing assembly 110.

In some embodiments, the frequency adjustment assembly 120 may include a piezoelectric frequency adjustment assembly. For example, the frequency adjustment assembly 120 may include a drive piezoelectric layer and a drive electrode layer. The drive piezoelectric layer undergoes deformation (e.g., contraction, elongation, etc.) in response to an electrical signal applied to the drive electrode layer. Exemplarily, the frequency adjustment assembly 120 may have an inverse piezoelectric effect that is capable of adjusting the deformation of the frequency adjustment assembly 120 by changing the magnitude of the applied electrical signal. In some embodiments, the frequency adjustment assembly 120 may include a thermoelectric frequency adjustment assembly, an electrostatic frequency adjustment assembly (e.g., a capacitive adjustment assembly), or an electromagnetic frequency adjustment assembly, etc. Correspondingly, the frequency adjustment assembly 120 may deform in response to an intermediate signal (e.g., thermal, electromagnetic, electrostatic, etc.) converted from an electrical signal. For example, the frequency adjustment assembly 120 may include a thermoelectric frequency adjustment assembly, and in the case where the electrical signal is converted to thermal energy, the thermoelectric frequency adjustment assembly may deform according to the thermal energy. It should be understood that the present invention describes the piezoelectric frequency adjustment assembly as an example only and that other forms (e.g., thermoelectric, electrostatic, electromagnetic, etc.) of the assembly may also serve as frequency adjustment assemblies for adjusting the resonance frequency of the sensing assembly 110.

In some embodiments, the frequency adjustment assembly 120 may deform the sensing piezoelectric layer 111 along a first direction. In some embodiments, the first direction may be a direction of a stress desired to be generated by the sensing piezoelectric layer 111. For example, the first direction may be a direction in which a tensile stress is desired to be generated by the sensing piezoelectric layer 111 or a direction in which a compressive stress is desired. In some embodiments, the first direction may also be a direction in which the sensing piezoelectric layer 111 deforms upon induced vibration and generates stress. For example, the first direction may be a direction of a tensile stress generated by the sensing piezoelectric layer 111 upon induced vibration or a direction of a compressive stress.

In some embodiments, a crystal direction of the frequency adjustment assembly 120 may be the same as the first direction so that a stress direction generated by the frequency adjustment assembly 120 is in the same direction as a stress direction generated by the sensing piezoelectric layer 111, which is capable of driving a deformation of the sensing piezoelectric layer 111 along the first direction. For example, the deformation (i.e., an initial deformation of the sensing piezoelectric layer 111) caused by the frequency adjustment assembly 120 to cause the sensing piezoelectric layer 111 to deform may be a tensile deformation, with the first direction being a direction x of the tensile stress generated by the sensing piezoelectric layer 111, and the crystal direction of the frequency adjustment assembly 120 may be a tensile stress direction along the direction x. In some embodiments, the first direction may also have a correspondence with a shape of the sensing piezoelectric layer 111. Two exemplary sensing piezoelectric layers 111 are provided below, respectively, to describe the first direction in detail.

In some embodiments, the sensing piezoelectric layer 111 may be a rectangle (e.g., a rectangular cantilever beam, a rectangular diaphragm, etc.), and the first direction may be in a length direction (long axis direction) of the sensing piezoelectric layer 111. In the case where the sensing piezoelectric layer 111 is a rectangle, the sensing piezoelectric layer 111 may sense a vibration causing a deformation (e.g., elongation or stretching) thereof in the length direction, thereby generating a stress in the length direction.

In some embodiments, when the sensing piezoelectric layer 111 is a rectangle, the sensor 100 (or the sensing assembly 110 and the frequency adjustment assembly 120) may be fixedly supported at both ends or peripherally supported. In some embodiments, the fixed support at both ends may include fixedly support at both ends in a length direction of the sensor 100 (or the sensing assembly 110 and the frequency conditioning assembly 120), or fixedly support at both ends in a width direction of the sensor 100 (or the sensing assembly 110 and the frequency conditioning assembly 120). In some embodiments, the peripheral support may include a peripheral support of the sensor 100 (or the sensing assembly 110 and the frequency adjustment assembly 120).

In some embodiments, the sensing piezoelectric layer 111 may be a circle, and the first direction may be a radial direction of the sensing piezoelectric layer 111. The radial direction may be a straight line direction in which a diameter of the sensing piezoelectric layer 111 is located. In the case where the sensing piezoelectric layer 111 is a circle, the sensing piezoelectric layer 111 may sense a vibration causing a deformation (e.g., elongation or stretching) thereof in the radial direction, thereby creating a stress in the radial direction.

In some embodiments, the crystal direction of the frequency adjustment assembly 120 may be along the radial direction of the sensing piezoelectric layer 111. The frequency adjustment assembly 120 may cause the sensing piezoelectric layer 111 to deform in the radial direction, such that the stress generated by the sensing piezoelectric layer 111 may be adjusted by changing the deformation of the frequency adjustment assembly 120.

In some embodiments, the sensor 100 (or the sensing assembly 110 and the frequency adjustment assembly 120) may be peripherally supported. In some embodiments, the peripheral support may refer to a peripheral support of the sensor 100 (or the sensing assembly 110 and the frequency adjustment assembly 120).

Embodiments of the present invention may change a stress value and a strain value (hereinafter referred to as stress) within the structure of the sensing piezoelectric layer 111 by setting the frequency adjustment assembly 120 and changing the voltage applied to the frequency adjustment assembly 120 to deform the frequency adjustment assembly 120 to drive the sensing piezoelectric layer 111 to deform the sensing piezoelectric layer 111, thereby adjusting the resonance frequency of the sensing assembly 110 and realizing the sensitivity adjustment of the sensor 100.

The substrate 130 may be configured to carry components of a functional device, such as for carrying the sensing assembly 110 and the frequency adjustment assembly 120. In some embodiments, the substrate 130 may sense an external vibration signal to generate vibration, and the sensing assembly 110 may deform in response to the vibration of the substrate 130, thereby outputting an electrical signal. In some embodiments, the substrate 130 may be a cavity. Correspondingly, the sensing assembly 110 and/or the frequency adjustment assembly 120 may be connected to a perimeter wall of the cavity of the substrate 130. The substrate 130 may transmit a vibration through the cavity or the perimeter wall of the cavity. In some embodiments, the sensing assembly 110 and/or the frequency adjustment assembly 120 may be connected to the substrate 130 by welding, bolting, adhesive bonding, etc.

In some embodiments, a shape of the cavity of the substrate 130 may be a regular shape such as a circle, a quadrilateral, a pentagon, a hexagon, a heptagon, an octagon, or other irregular shape. For example, the substrate 130 may be a quadrilateral cavity. In some embodiments, the sensing assembly 110 and/or the frequency adjustment assembly 120 may be connected to the perimeter wall of the cavity of the substrate 130. In some embodiments, the shape of the substrate 130 may be adapted to carry the sensing assembly 110 and the frequency adjustment assembly 120 based on the shape of the sensing assembly 110 and the frequency adjustment assembly 120.

In some embodiments, the size of the cavity in the substrate 130 may affect the size of the sensing assembly 110 and the frequency tuning assembly 120. In some embodiments, a size of the quadrilateral cavity may be in a range of 0.5 mm x 0.5 mm - 5 mm x 5 mm. In some embodiments, the size of the quadrilateral cavity may be in a range of 1.0 mm x 1.0 mm-2.5 mm x 2.5 mm.

An exemplary sensor 100 is provided below to describe how the sensing assembly 110, the frequency adjustment assembly 120, and the substrate 130 are set up with respect to each other.

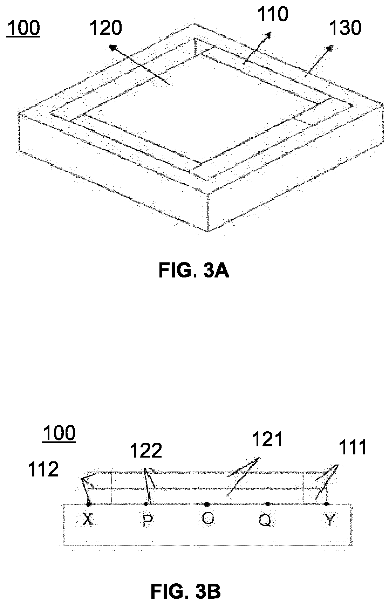

FIG. 2A is a top view illustrating the exemplary sensor 100 according to some embodiments of the present invention. FIG. 2B is a front view illustrating the exemplary sensor 100 according to some embodiments of the present invention. FIG. 2C is a side view illustrating the exemplary sensor 100 according to some embodiments of the present invention. FIG. 3A is a schematic diagram illustrating a three-dimensional structure of the exemplary sensor 100 according to some embodiments of the present invention. FIG. 3B is a schematic diagram illustrating a front view structure of the exemplary sensor 100 according to some embodiments of the present invention. It should be understood that the sensor 100 shown in FIGs. 2B, 2C, and 3B has a magnified thickness of both the piezoelectric layer and the electrode layer in order to facilitate the illustration of a setting relationship between the piezoelectric layer (e.g., the sensing piezoelectric layer 111, the drive piezoelectric layer 121) and the electrode layer (e.g., the sensing electrode layer 112, the drive electrode layer 122).

As shown in FIGs. 2A-2C and FIGs. 3A-3B, the sensor 100 may include a sensing assembly 110, a frequency adjustment assembly 120, and a substrate 130. The substrate 130 is configured carry the sensing assembly 110 and the frequency adjustment assembly 120. In some embodiments, the sensing assembly 110 may include a sensing piezoelectric layer 111 and a sensing electrode layer 112. In some embodiments, the sensing assembly 110 may include a plurality of sensing piezoelectric layers 111 and a plurality of sensing electrode layers 112. By way of example only, as shown in FIGs. 2B and 3B, the sensing assembly 110 may include two sensing piezoelectric layers 111 and three sensing electrode layers 112, and the two sensing piezoelectric layers 111 and the three sensing electrode layers 112 may be provided alternately along a thickness direction of the sensing assembly 110. In some embodiments, the frequency adjustment assembly 120 may include a drive piezoelectric layer 121 and a drive electrode layer 122. In some embodiments, the frequency adjustment assembly 120 may include a plurality of drive piezoelectric layers 121 and a plurality of drive electrode layers 122. By way of example only, as shown in FIGs. 2B and 3B, the frequency adjustment assembly 120 may include two drive piezoelectric layers 121 and three drive electrode layers 122, and the two drive piezoelectric layers 121 and the three drive electrode layers 122 may be alternately disposed along a thickness direction of the frequency adjustment assembly 120. In some embodiments, the sensing piezoelectric layer 111 and the drive piezoelectric layer 121 may be in a same plane. For example, as shown in FIGs. 2B and 3B, each sensing piezoelectric layer 111 may have a corresponding drive piezoelectric layer 121, and the sensing piezoelectric layer 111 and the corresponding drive piezoelectric layer 121 may be in the same plane.

The drive piezoelectric layer 121 may be configured as a component that provides an inverse piezoelectric effect. In some embodiments, the drive piezoelectric layer 121 may deform in response to an applied electrical signal to drive the sensing piezoelectric layer 111 to deform, thereby altering the stress of the sensing piezoelectric layer 111. In some embodiments, the drive piezoelectric layer 121 may be deformed to drive the sensing piezoelectric layer 111 to deform. Exemplarily, referring to FIG. 2B, a contraction of the drive piezoelectric layer 121 may drive an elongation of the sensing piezoelectric layer 111 along a direction a; conversely, an elongation of the drive piezoelectric layer 121 may drive a contraction of the sensing piezoelectric layer 111 along the direction a.

In some embodiments, the drive piezoelectric layer 121 may be a piezoelectric polymer film obtained by a deposition process for semiconductors (e.g., magnetron sputtering, MOCVD). In some embodiments, the material of the drive piezoelectric layer 121 may include a piezoelectric crystal material and a piezoelectric ceramic material. In some embodiments, the piezoelectric crystal may refer to a piezoelectric single crystal. Exemplary piezoelectric crystal materials may include crystals, sphalerite, galena, tourmaline, rhodochrosite, GaAs, barium titanate and its derived structural crystals, $KH2PO4$, $NaKC4H4O6-4H2O$ (rosette salt), etc., or any combination thereof. In some embodiments, the piezoelectric ceramic material refers to a piezoelectric polycrystal consisting of an irregular collection of microscopic grains obtained by a solid phase reaction and sintering between powder grains of different materials. Exemplarily, the piezoelectric ceramic material may include barium titanate (BT), lead zirconate titanate (PZT), lead barium lithium niobate (PBLN), modified lead titanate (PT), aluminum nitride (AIN), zinc oxide (ZnO), etc., or any combination thereof. In some embodiments, the material of the piezoelectric layer 410 may also be a piezoelectric polymer material. Exemplarily, the piezoelectric polymer material may include polyvinylidene fluoride (PVDF) etc.

In some embodiments, a thickness of the drive piezoelectric layer 121 may be in a range of 0.5 $\mu$m-5 $\mu$m. In some embodiments, the thickness of the drive piezoelectric layer 121 may be in a range of 0.5 $\mu$m-5 $\mu$m. In some embodiments, the thickness of the drive piezoelectric layer 121 may be in a range of 0.5 $\mu$m-2 $\mu$m. For example, the material of the drive piezoelectric layer 121 may include PZT, and the thickness of the drive piezoelectric layer 121 may be in a range of 0.5 $\mu$m-2 $\mu$m.

In some embodiments, the drive piezoelectric layer 121 may have a single-layer structure or may have a multi-layer structure. In the case where the drive piezoelectric layer 121 adopts a multi-layer structure, a deformation adjustment range of the drive piezoelectric layer 121 may be increased, which may increase the adjustment range of the resonance frequency of the sensing assembly 110. In some embodiments, at least two of the drive piezoelectric layers 121 may be provided by way of cascading. For example, the plurality of drive piezoelectric layers 121 may be provided in a stack along a thickness direction of the drive piezoelectric layers 121.

In some embodiments, there is a correspondence between the magnitude of the deformation of the drive piezoelectric layer 121 and an applied electrical signal (e.g., the magnitude of the voltage), and thus, the deformation of the drive piezoelectric layer 121 may be adjusted by varying the voltage, thereby adjusting the stress of the sensing piezoelectric layer 111 and the resonance frequency of the sensing assembly 110. Exemplarily, according to the above equation (4), increasing the voltage of the drive piezoelectric layer 121 (e.g., the electric field strength $E_j$) may increase the deformation of the drive piezoelectric layer 121 (e.g., is the displacement of the piezoelectric material), and thus the stress of the sensing piezoelectric layer 111 may be increased, and the resonance frequency of the sensing assembly 110 may be increased. As another example, reducing the voltage applied to the driving piezoelectric layer 121 may reduce the deformation of the drive piezoelectric layer 121, which may reduce the stress of the sensing piezoelectric layer 111, reduce the resonance frequency of the sensing assembly 110, and realize the adjustment of the resonance frequency.

The drive electrode layer 122 may be a component that provides electrical energy. For example, the drive electrode layer 122 may provide a voltage to drive the piezoelectric layer 121. In some embodiments, the voltage of the drive electrode layer 122 may drive the drive piezoelectric layer 121 to elongate or contract. In some embodiments, the voltage of the drive electrode layer 122 may drive the drive piezoelectric layer 121 to contract. Correspondingly, the drive piezoelectric layer 121 may contract to drive a tensile deformation of the sensing piezoelectric layer 111 and cause the sensing piezoelectric layer 111 to generate a tensile stress. Exemplarily, as shown in FIG. 2B, the voltage of the drive electrode layer 122 may drive the drive piezoelectric layer 121 at both ends to contract, causing the drive piezoelectric layer 121 to pull the sensing piezoelectric layer 111 along the direction a, causing the sensing piezoelectric layer 111 to elongate and generate a tensile stress along the direction a, in order to adjust the resonance frequency of the sensing assembly 110.

In some embodiments, adjusting the voltage of the drive electrode layer 122 may change a contraction degree of the drive piezoelectric layer 121. Correspondingly, in some embodiments, changing the contraction degree of the drive piezoelectric layer 121 may adjust an elongation degree of the sensing piezoelectric layer 111 and a magnitude of the tensile stress, thereby adjusting the resonance frequency of the sensing assembly 110. Exemplarily, increasing the voltage of the drive electrode layer 122 may increase the contraction degree of the drive piezoelectric layer 121, increase the elongation degree of the sensing piezoelectric layer 111, and increase the tensile stress, thereby increasing the resonance frequency of the sensing assembly 110. Conversely, reducing the voltage of the drive electrode layer 122 may reduce the contraction degree of the drive piezoelectric layer 121, reduce the elongation degree of the sensing piezoelectric layer 111, and reduce the tensile stress, thereby reducing the resonance frequency of the sensing assembly 110.

In some embodiments, a material of the drive electrode layer 122 may include copper (Cu), platinum (Pt), molybdenum (Mo), titanium (Ti), etc., or any combination thereof. In some embodiments, a thickness of the drive electrode layer 122 may be in a range of 0.1 μm-2 μm. For example, the material of the drive electrode layer 122 may include a Pt/Ti composite metal, and the thickness of the drive electrode layer 122 may be in a range of 0.1 μm-0.5 μm.

In some embodiments, the drive electrode layer 122 may be provided on at least one surface of the drive piezoelectric layer 121. In some embodiments, the drive electrode layer 122 may be provided on two opposite surfaces of the drive piezoelectric layer 121, respectively. In some embodiments, the drive electrode layer 122 may also be provided between two adjacent drive piezoelectric layers 121 in the multilayer drive piezoelectric layer 121 to provide a voltage to the two adjacent drive piezoelectric layers 121. In some embodiments, the drive electrode layer 122 may be provided on a surface of the drive piezoelectric layer 121 by one or more affixing methods, such as deposition, coating, inlay, fit, etc.

In some embodiments, the sensing piezoelectric layer 111 and the drive piezoelectric layer 121 may be in a same plane. Exemplarily, as shown in FIGs. 2B and 3B, the sensing piezoelectric layer 111 and the corresponding drive piezoelectric layer 121 may be distributed in a same plane. In some embodiments, the sensing piezoelectric layer 111 and the corresponding drive piezoelectric layer 121 in the same plane may be physically connected. The "physical connection" described in the present invention can be understood as a connection between different parts of the same structure, or after preparing different parts or structures separately, fixing and connecting the separate parts or structures by welding, riveting, snap-fitting, bolting, adhesive bonding, etc., or fixing and connecting the separate parts or structures by welding, riveting, snap-fitting, bolting, adhesive bonding, etc., or fixing and connecting the separate parts or structures during the preparation process, or during the preparation process, a first component or structure is deposited on a second component or structure through physical deposition (e.g., physical vapor deposition) or chemical deposition (e.g., chemical vapor deposition).

In some embodiments, the connection between the drive piezoelectric layer 121 and the sensing piezoelectric layer 111 is susceptible to fracture when the drive piezoelectric layer 121 and the sensing piezoelectric layer 111 deform. In some embodiments, in order to increase a contact area of the sensing piezoelectric layer 111 and the drive piezoelectric layer 121, avoid insufficient bonding force at the connection of the sensing piezoelectric layer 111 and the drive piezoelectric layer 121, and reduce the possibility of fracture at the connection, the sensing piezoelectric layer 111 and the corresponding drive piezoelectric layer 121 may be connected by a mortise-and-tenon structure. For example, the sensing piezoelectric layer 111 may be provided with a convex portion, and the driving piezoelectric layer 121 may be provided with a concave portion, and the convex portion and the concave portion may be fitted to each other to increase the contact area of the sensing piezoelectric layer 111 and the drive piezoelectric layer 121.

In some embodiments, the drive piezoelectric layer 121 and the sensing piezoelectric layer 111 may be made by a one-piece molding process to ensure that a junction of the sensing piezoelectric layer 111 and the drive piezoelectric layer 121 is stable and to avoid fracture due to insufficient bonding force at the junction. In some embodiments, the sensing piezoelectric layer 111 and the drive piezoelectric layer 121 may be an integral structure made of the same material (e.g., deposited), where the sensing assembly 110 and the frequency adjustment assembly are formed after arranging different regions on a surface of the integral structure with the sensing electrode layer 112 and the drive electrode layer 122, respectively. In some embodiments, an integral electrode layer may be arranged on the surface of the integral structure, and the integral electrode layer may be divided into the sensing piezoelectric layer 111 and the drive piezoelectric layer 121 by, e.g., dividing the integral electrode layer. For example, the electrode layer may be made on the piezoelectric layer (i.e., a sum of the sensing piezoelectric layer 111 and the drive piezoelectric layer 121) after the sensing piezoelectric layer 111 and the drive piezoelectric layer 121 have been deposited through a single deposition, and then be divided by utilizing a segmentation technique, such as etching, cutting, engraving, etc., to obtain the sensing electrode layer 112 and the drive electrode layer 122. In some embodiments, a corresponding sensing electrode layer 112 and a corresponding drive electrode layer 122 may be fabricated at a corresponding sensing piezoelectric layer 111 and a corresponding drive piezoelectric layer 121, respectively, after the sensing piezoelectric layer 111 and the drive piezoelectric layer 121 are deposited by one deposition.

In some embodiments, the sensing piezoelectric layer 111 and the drive piezoelectric layer 121 may be distributed in a variety of ways. In some embodiments, a manner in which the piezoelectric layer is distributed may be related to a stress distribution. In some embodiments, a diaphragm comprising the sensing piezoelectric layer 111 and the drive piezoelectric layer 121 may be physically approximated to be equivalent to a piezoelectric beam that is fixedly supported at both ends, with each end of the piezoelectric beam being fixed to the substrate 130. In the event of deformation of the piezoelectric beam, the stress in a region near the fixedly supported end of the piezoelectric beam is greater than in a center region of the piezoelectric beam away from the fixedly supported end. In some embodiments, the diaphragm comprising the sensing piezoelectric layer 111 and the drive piezoelectric layer 121 may be physically approximated to be equivalent to a peripherally supported piezoelectric membrane, with the periphery of the piezoelectric membrane fixed to the substrate 130. In the event of deformation of the piezoelectric membrane, the stress in a region near the fixedly supported end of the piezoelectric membrane is greater than in a center region of the piezoelectric membrane away from the fixedly supported end of the piezoelectric membrane.

In some embodiments, a stress in a region of higher stress (e.g., a region near a fixed end) may be further increased in order to obtain a larger output signal from the sensing assembly 110. For example, the drive piezoelectric layer 121 may be in a middle of the sensing piezoelectric layer 111. That is, the sensing piezoelectric layer 111 may be provided in the region of higher stress, i.e., a region near the fixed end, to enable the sensing piezoelectric layer 111 to obtain a larger signal output, while the drive piezoelectric layer 121 is provided in a region of lower stress, i.e., a center region away from the fixed end. Exemplarily, as shown in FIG. 3A-FIG. 3B, point X and point Y are fixed support ends of the sensing piezoelectric layer 111, i.e., the sensing piezoelectric layer 111 is fixedly supported at both ends. The sensing assembly 110 may be distributed on both sides of the frequency adjustment assembly 120 (i.e., near the points X and Y) so that the drive piezoelectric layer 121 is provided in the middle of the sensing piezoelectric layer 111.

In some alternative embodiments, in order to reduce the risk of fracture due to an excessive stress in the region of higher stress, the drive piezoelectric layer 121 may be distributed in the region of higher stress, i.e., near the fixed support end. For example, the sensing piezoelectric layer 111 may be in the middle of the drive piezoelectric layer 121, with the drive piezoelectric layer 121 near the fixed support end. That is, the sensing piezoelectric layer 111 may be provided in the region of lower stress, i.e., in the center region away from the fixed support end; and the drive piezoelectric layer 121 drives the region of higher stress of the piezoelectric layer 121, i.e., in the region near the fixed support end, in order to prevent the sensing piezoelectric layer 111 from being deformed too much and fractured. Exemplarily, as shown in FIG. 2A-FIG. 2B, point X' and point Y' are fixedly supported ends of the sensing piezoelectric layer 111, i.e., the sensing piezoelectric layer 111 is fixedly supported at both ends. The frequency adjustment assembly 120 may be distributed on both sides of the sensing assembly 110 (i.e., near the points X' and Y') so that the sensing piezoelectric layer 111 is provided in the middle of the drive piezoelectric layer 121.

In some embodiments, a magnitude of the output signal of the sensing piezoelectric layer 111 is related to a length of the sensing piezoelectric layer 111 (or the drive piezoelectric layer 121) along the first direction when a length of the sensor 100 along the first direction is certain. For example, when the sensing piezoelectric layer 111 and the drive piezoelectric layer 121 are in the same plane, and when the length of the sensor 100 along the first direction is certain, the longer the length of the drive piezoelectric layer 121 along the first direction is, the shorter the length of the sensing piezoelectric layer 111 along the first direction is, which in turn results in a smaller output signal of the sensing piezoelectric layer 111; correspondingly, the shorter the length of the driving piezoelectric layer 121 along the first direction is, the longer the length of the sensing piezoelectric layer 111 along the first direction is, which in turn results in a larger output signal of the sensing piezoelectric layer 111.

In some embodiments, the sensing piezoelectric layer 111 may be arranged in the middle of the drive piezoelectric layer 121 in order to reduce the risk of fracture due to an excessive stress in the region of higher stress. In this case, the length of the drive piezoelectric layer 121 relative to the sensing piezoelectric layer 111 along the first direction may be made as small as possible in order to increase the output signal of the sensing piezoelectric layer 111. For example, the length of the drive piezoelectric layer 121 along the first direction may be in a range of 5%-50% of the length of the sensing piezoelectric layer 111 along the first direction. As another example, the length of the drive piezoelectric layer 121 along the first direction may be in a range of 5%-30% of the length of the sensing piezoelectric layer 111 along the first direction. As another example, the length of the drive piezoelectric layer 121 along the first direction may be in a range of 10%-25% of the length of the sensing piezoelectric layer 111 along the first direction.

In some embodiments, the drive piezoelectric layer 121 may be arranged in the middle of the sensing piezoelectric layer 111 in order to obtain a larger output signal from the sensing assembly 110. In this case, the length of the drive piezoelectric layer 121 along the first direction with respect to the sensing piezoelectric layer 111 may be made as large as possible in order to reduce the risk of fracture in the region of higher stress due to excessive stress. For example, the length of the drive piezoelectric layer 121 along the first direction may be in a range of 100%-500% of the length of the sensing piezoelectric layer 111 along the first direction. As another example, the length of the drive piezoelectric layer 121 along the first direction may be in a range of 150%-300% of the length of the sensing piezoelectric layer 111 along the first direction.

In some embodiments, the sensing piezoelectric layer 111 is a piezoelectric beam fixedly supported at both ends. During deformation of the piezoelectric beam, a stress distribution of the piezoelectric beam is such that, starting from the fixedly supported end of the piezoelectric beam to a position in the middle, the stress in the piezoelectric beam may decrease from a tensile stress to zero, and then increase from zero to a compressive stress. In some embodiments, a stress critical point (i.e., a zero point where the tensile and compressive stresses cancel each other out) is located at or near a position 1/4 of the length of the piezoelectric beam along the first direction. Certainly, different shapes of piezoelectric beams may correspond to different positions of stress critical points. In some embodiments, the sensing electrode layer 112 may be provided in a compressive stress region or a tensile stress region of the sensing piezoelectric layer 111 to avoid partial offsetting of the tensile and compressive stresses when sensing vibrations, thereby increasing the output of the signal and improving the sensitivity of the sensor 100. The tensile stress region may be a region from the fixedly supported end of the piezoelectric beam to the stress critical point. The compressive stress region may be a region from the stress critical point to the center of the piezoelectric beam.

Exemplarily, as shown in FIG. 3B, points P and Q may be stress critical points of the piezoelectric beam, points X and Y may be fixedly supported ends of the piezoelectric beam, a region from point X to where point P is located and a region from point Y to where Q is located may be a region of compressive stress, and the region from point P to where point Q is located (i.e., the collection of the region from point P to where point O is located and the region from point O to where Q is located) may be a region of tensile stress.

In some embodiments, since the stress critical point of the piezoelectric beam or the piezoelectric membrane may be at 1/4 of the total length along the first direction on the piezoelectric beam or the piezoelectric membrane near the fixedly supported end, the sensing electrode layer 112 may be distributed within 1/4 of the length of the piezoelectric beam or the piezoelectric membrane near the fixedly supported end of the piezoelectric beam or the piezoelectric membrane along the total length of the piezoelectric beam or the piezoelectric membrane along the first direction. In some embodiments, when the sensing piezoelectric layer 111 is in the same plane as the drive piezoelectric layer 121, the length of the piezoelectric beam or the piezoelectric membrane along the first direction may be the total length of the sensing piezoelectric layer 111 and the drive piezoelectric layer 121 along the first direction (e.g., a sum of a length of the sensing piezoelectric layer and a length of the drive piezoelectric layer along the first direction). Exemplarily, as shown in FIG. 3B, the sensing electrode layer 112 may be distributed in a region from point X to a region where point P is located and from point Y to a region where Q is located.

In some embodiments, a position of the stress critical point of the piezoelectric beam may be adjusted by attaching a mass block. In some embodiments, the mass block may be provided in a region of the piezoelectric beam near a center point to adjust the position of the stress critical point. Exemplarily, the greater the mass of the mass block is, the closer the stress critical point is to the center point of the piezoelectric beam; conversely, the lesser the mass of the mass block is, the closer the stress critical point is to 1/4 of the fixed support end of the piezoelectric beam. In some embodiments, the mass block may also be provided in other regions of the piezoelectric beam, such as at the fixed support end, near the 1/4 of the fixed support end of the piezoelectric beam, etc.

In embodiments of the present invention, by designing the distribution of the sensing electrode layer 112, the sensing assembly 110 can be prevented from partially offsetting the tensile and compressive stresses when sensing vibrations, thereby increasing the output of the signal of the sensing assembly 110 and improving the sensitivity of the sensor 100.

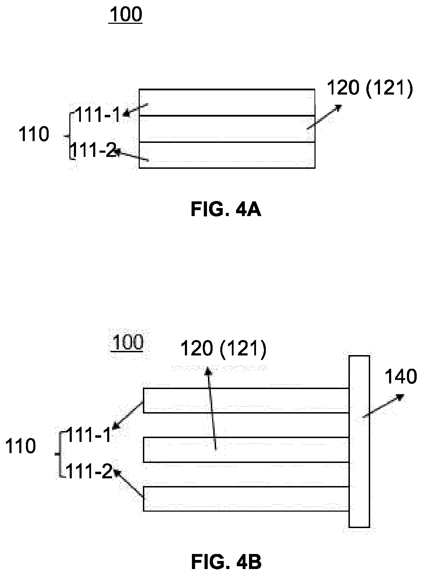

In some embodiments, the sensing piezoelectric layer 111 and the drive piezoelectric layer 121 may also not be provided in the same plane. FIG. 4A is a schematic diagram illustrating the exemplary sensor according to some embodiments of the present invention. FIG. 4B is a schematic diagram illustrating the exemplary sensor according to some embodiments of the present invention

In some embodiments, the sensing piezoelectric layer 111 and the drive piezoelectric layer 121 may be provided in a stack, as shown in FIG. 4A. In some embodiments, the sensing assembly 110 may include a plurality of sensing piezoelectric layers 111, and the frequency adjustment assembly 120 may include a plurality of drive piezoelectric layers 121. To simplify the structure, FIG. 4A and FIG. 4B are illustrated only with two sensing piezoelectric layers and one driving piezoelectric layer, and it should be understood that the sensing assembly 110 may include only one sensing piezoelectric layer 111 or more than two sensing piezoelectric layers 111, and the frequency adjustment assembly 120 may include one or more drive piezoelectric layers 121, and is not limited herein. As shown in FIG. 4A, the sensing assembly 110 may include a first sensing piezoelectric layer 111-1 and a second sensing piezoelectric layer 111-2; and the frequency adjustment assembly 120 may include a drive piezoelectric layer 121. In some embodiments, the drive piezoelectric layer 121 may be disposed between the first sensing piezoelectric layer 111-1 and the second sensing piezoelectric layer 111-2 for transmitting deformation, directly or indirectly, to the first sensing piezoelectric layer 111-1 and the second sensing piezoelectric layer 111-2. As shown in FIG. 4A, the first sensing piezoelectric layer 111-1 may be stacked on the drive piezoelectric layer 121, and the drive piezoelectric layer 121 may be further stacked on the second sensing piezoelectric layer 111-2, so that the sensing piezoelectric layers (the first sensing piezoelectric layer 111-1 and the second sensing piezoelectric layer 111-2) are located on surfaces of higher stress. When the drive piezoelectric layer 121 undergoes stretching, it is easier to change the resonance frequency of the sensing assembly 110 so that the resonance frequency is shifted towards lower or higher frequencies to increase the sensitivity of the sensing assembly 110 at lower or higher frequencies. In some embodiments, as shown in FIG. 4B, the first sensing piezoelectric layer 111-1, the drive piezoelectric layer 121, and the second sensing piezoelectric layer 111-2 may be distributed parallel and spaced apart from each other, and one end of the first sensing piezoelectric layer 111-1, one end of the drive piezoelectric layer 121, and one end of the second sensing piezoelectric layer 111-2 may be connected by a connection assembly 140. When the drive piezoelectric layer 121 deforms under the action of an electrical signal, the deformation is transmitted to the first sensing piezoelectric layer 111-1 and the second sensing piezoelectric layer 111-2 through the connection assembly 140, so that the sensing piezoelectric layer 111 deforms, thereby changing the resonance frequency of the sensing assembly 110. As shown in FIG. 4B, the drive piezoelectric layer 121 may be provided between the first sensing piezoelectric layer 111-1 and second sensing piezoelectric layer 111-2 so that the sensing piezoelectric layers (the first sensing piezoelectric layer 111-1 and the second sensing piezoelectric layer 111-2) are located on surfaces of higher stress. When the drive piezoelectric layer 121 undergoes expansion and contraction, it is easier to change the resonance frequency of the sensing assembly 110 so that the resonance frequency is shifted towards low or high frequencies to increase the sensitivity of the sensing assembly 110 at low or high frequencies.

It should be understood that the sensing electrode layer 112 (not shown) may cover at least one surface of the sensing piezoelectric layer 111 (e.g., the first sensing piezoelectric layer 111-1 and the second sensing piezoelectric layer 111-2); and the drive electrode layer 122 (not shown) may cover at least one surface of the drive piezoelectric layer 121.

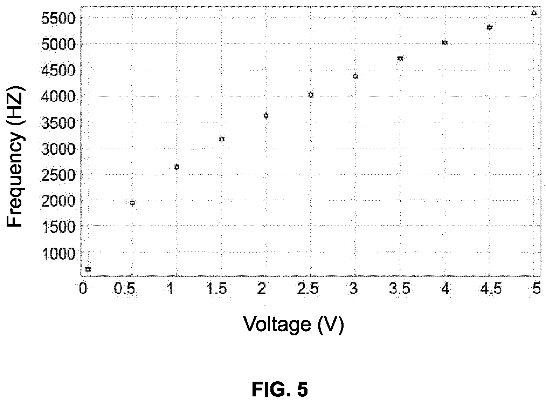

FIG. 5 is a schematic diagram illustrating a relationship between a resonance frequency and a voltage of the exemplary sensor according to some embodiments of the present invention. As shown in FIG. 5, when a voltage applied to the frequency adjustment assembly 120 (i.e., the voltage of the drive electrode layer 122) is incremented in a range of 0 to 5 V, the resonance frequency of the sensor 100 is monotonically incremented from about 300 Hz to about 5500 Hz. Further, when the voltage of the drive electrode layer 122 is at 0V, the resonance frequency of the sensor 100 is about 300Hz; when the voltage of the drive electrode layer 122 is at 5V, the resonance frequency of the sensor 100 is about 5500Hz. In some other embodiments, a difference between the resonance frequency of the sensor 100 when the voltage of the drive electrode layer 122 is 5V and the resonance frequency of the sensor 100 when the voltage of the drive electrode layer 122 is 0V is not less than 2 kHz. By changing the voltage on the drive electrode layer 122, a wide range of adjustment of the resonance frequency of the sensor may be realized.

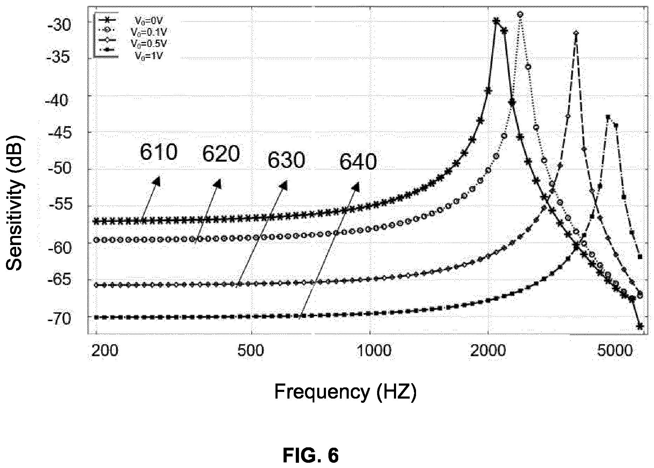

FIG. 6 is a schematic diagram illustrating a frequency response curve of the exemplary sensor according to some embodiments of the present invention. Curve 610 shows a frequency response curve of the sensor 100 at a voltage V0=0V of the drive electrode layer 122; curve 620 shows a frequency response curve of the sensor 100 at a voltage V0=0.1V of the drive electrode layer 122; curve 630 shows a frequency response curve of the sensor 100 at a voltage V0=0.5V of the drive electrode layer 122; and curve 640 shows a frequency response curve of the sensor 100 at a voltage V0=1V of the drive electrode layer 122. V0=1V; and curve 640 is the frequency response curve of the sensor 100 at the voltage V0=1V of the driving electrode layer 122. As shown in curve 610-curve 640, when a voltage of 0 to 1 V is applied to the frequency adjustment assembly 120, a resonance frequency of the sensor 100 increases from about 2 kHz to about 5 kHz; and a sensitivity of the sensor 100 decreases from about -57 dB to about -70 dB in a range of frequencies from about 0 Hz to about 1000 Hz, realizing a wide range of resonance frequency and device sensitivity.

In some embodiments, during the preparation of a sensor, in order to avoid the sensing piezoelectric layer in the sensor from being subjected to excessive stress, wrinkles, breakage, or even sensor failure, the stress is usually regulated by changing parameters (e.g., a deposition temperature, a flow rate of a deposition power gas, etc.) in a film deposition process. However, this method results in a long period of regulation and high cost. According to the sensor 100 described in some embodiments of the present invention, a stress to which the sensing piezoelectric layer 111 is subjected is placed in an adjustable range by setting the frequency adjustment assembly 120, and when the sensor 100 is applied to different scenarios, an active stress regulation of the sensing piezoelectric layer 111 may be realized by varying the magnitude of the voltage applied thereto to the frequency adjustment assembly 120. Thus, the sensor 100 described herein not only shortens the modulation cycle, but also saves production costs.

In some embodiments, the sensor 100 described herein may be applied to adaptive regulation of a microphone or a speaker. For example, the microphone may be adjusted to a suitable resonance frequency and an operating bandwidth according to different scenarios, so that sounds in a target frequency range can be captured more efficiently. Simply put, different noise environments may have different effects on the performance of the microphone. Upon recognizing that a particular frequency range is noisy, the resonance frequency of the microphone (e.g., a piezoelectric component in the microphone) may be adjusted to avoid or move away from the particular frequency range, thereby avoiding the effect of that noise on the microphone, in accordance with embodiments of the present invention. Alternatively, upon obtaining the frequency range in which the target sound to be captured is located, the resonance frequency of the microphone (e.g., the piezoelectric assembly in the microphone) may be adjusted so that it is near or located in the frequency range in order to increase a sensitivity of the capture of the target sound, in accordance with embodiments of the present invention. Alternatively, when a sound signal to be captured is too loud (e.g., the volume is greater than a certain threshold), the resonance frequency of the microphone may be adjusted according to embodiments of the present invention in order to reduce the sensitivity of the microphone in the frequency range corresponding to the excessively loud volume of the microphone, and to avoid the excessively loud volume of the volume of sound causing a distortion of the information captured by the microphone or causing damage to the microphone. Similarly, the resonance frequency of the speaker may be adjusted to a suitable frequency range according to a magnitude of an ambient noise, a strength of an audio signal to be played, or a target frequency range selected by a user, etc., so as to change the sensitivity of the speaker in different frequency bands to satisfy different application requirements.

In some embodiments, the sensor 100 described herein may be applied in an accelerometer. The accelerometer may be used for the detection of a state of motion of a particular object, and by adjusting a sensitivity of the accelerometer (e.g., by varying the resonance frequency to vary the sensitivity in a particular frequency range), the effect of the accelerometer on external noise, and/or the responsiveness of the accelerometer to a target signal may be reduced, and/or the responsiveness of the accelerometer to a target signal may be increased, thereby more accurately reflecting the state of motion of said particular object. For example, a mobile device (e.g., a cell phone, a wearable device) may contain a sensor 100 as an accelerometer, and when a user carrying the mobile device is in different scenarios, the resonance frequency or sensitivity of the sensor 100 may be adjusted in different ways. For example, when the mobile device is carried in different means of transportation, the noise (frequency band) of the different means of transportation may be different, so the resonance frequency of the accelerometer may be adjusted to different frequency bands to avoid the environment from interfering with the accuracy of the accelerometer in measuring the real-time state of the mobile device. For example, when a user carries a cell phone in a car, a resonance peak of the sensor 100 in the cell phone may be adjusted to a frequency band that is far away from the noise (e.g., noise generated by vibration of the road surface) in the car. As another example, when the user carries the cell phone in an airplane, a resonance peak of the sensor 100 in the accelerometer of the cell phone may be adjusted to be on a frequency band away from noise on the airplane (e.g., noise generated by airflow or vibration of the airplane's wings). As another example, when the cell phone is dropped and subjected to a low-frequency shock load, the resonance frequency of the sensor 100 in the cell phone accelerometer may be adjusted to a high-frequency band to reduce its sensitivity in the low-frequency band, thereby reducing the likelihood that the low-frequency shock load will cause damage to the sensor 100. As another example, when a user carries a cell phone or other wearable device for exercise, the sensor 100 may be adjusted to increase the sensitivity of the cell phone or wearable device in detecting target motion information in order to better detect the user's motion information.

In some embodiments, the sensor 100 described herein may be applied in an in-vehicle system. Since cars encounter different noise environments during driving (e.g., noise on a bumpy road and noise on a flat road have different frequency distributions), in order to avoid noise from affecting the normal operation of the sensor 100, a resonance peak of the sensor 100 may be adjusted to avoid or move away from the frequency band where the main noise is located when the car is detected to be in different noise environments, and to reduce the response of the sensor 100 to the noise.

In some embodiments, the resonance frequency of the sensor 100 is related to its measurable bandwidth. For example, the higher the resonance frequency of the sensor 100 is, the wider the measurable bandwidth of the sensor may be. In some embodiments, an adaptive accelerometer comprising the sensor 100 may adjust the resonance frequency of the sensor 100 to meet different measurement bandwidths depending on different scenarios. For example, when detecting an acceleration value of about 1 g generated by a moving or static mobile device (e.g., a cell phone, a wearable device), the resonance frequency of the adaptive accelerometer may be adjusted so that the measurable bandwidth is about 0 Hz. As another example, when detecting the state of a car under high acceleration (e.g., an acceleration value of about 200g generated during a collision) or low acceleration (e.g., an acceleration value of about 2g generated during steady acceleration or deceleration of the car), the resonance frequency of the adaptive accelerometer may be adjusted so that its measurable bandwidth is about 100Hz. As another example, when detecting an acceleration value (e.g., around 25g) in a stable or tilted state of a platform in an industrial field, the resonance frequency of the adaptive accelerometer may be adjusted so that its measurable bandwidth is in a range of 5Hz-500Hz. As another example, when detecting an acceleration value (e.g., around 5g) in a weapon or aircraft navigation application, the resonance frequency of the adaptive accelerometer may be adjusted so that its measurable bandwidth is in a range of less than 1kHz. As another example, when detecting an acceleration value (e.g., around 15g) in a submarine or aircraft navigation application, the resonance frequency of the adaptive accelerometer may be adjusted so that its measurable bandwidth is in a range greater than 300Hz.

It should be understood that the sensor 100 described herein may be applied to any device having a piezoelectric structure for adjusting a stress distribution, a resonance frequency, or a sensitivity, without limitation herein.

Possible beneficial effects of the embodiments of the present invention include, but are not limited to, that the embodiments of the present invention may be configured change a stress value and a strain value within the structure of the sensing piezoelectric layer by providing a frequency adjustment assembly, changing a voltage applied to the frequency adjustment assembly to deform the frequency adjustment assembly to drive the sensing piezoelectric layer to deform the sensing piezoelectric layer, changing the stress value and strain value within the structure of the sensing piezoelectric layer, thereby adjusting the resonance frequency of the sensing assembly and realizing the adjustment of the sensitivity of the sensor.

The basic concepts have been described above, apparently, in detail, as will be described above, and does not constitute limitations of the disclosure. Although there is no clear explanation here, those skilled in the art may make various modifications, improvements, and modifications of present invention.

At the same time, present invention uses specific words to describe the embodiments of the present invention. As "one embodiment", "an embodiment", and/or "some embodiments" means a certain feature, structure, or characteristic of at least one embodiment of the present invention. Therefore, it is emphasized and should be appreciated that two or more references to "an embodiment" or "one embodiment" or "an alternative embodiment" in various parts of present invention are not necessarily all referring to the same embodiment. Further, certain features, structures, or features of one or more embodiments of the present invention may be combined.

In addition, unless clearly stated in the claims, the order of processing elements and sequences, the use of numbers and letters, or the use of other names in the present invention are not used to limit the order of the procedures and methods of the present invention. For example, although the implementation of various components described above may be embodied in a hardware device, it may also be implemented as a software only solution, e.g., an installation on an existing server or mobile device.

Similarly, it should be appreciated that in the foregoing description of embodiments of the present invention, various features are sometimes grouped together in a single embodiment, figure, or description thereof for the purpose of streamlining the disclosure aiding in the understanding of one or more of the various embodiments. However, this disclosure does not mean that the present invention object requires more features than the features mentioned in the claims. Rather, claimed subject matter may lie in less than all features of a single foregoing disclosed embodiment.

In some embodiments, the numbers expressing quantities of ingredients, properties, and so forth, used to describe and claim certain embodiments of the application are to be understood as being modified in some instances by the term "about," "approximate," or "substantially". Unless otherwise stated, "about," "approximate," or "substantially" may indicate ±20% variation of the value it describes. Accordingly, in some embodiments, the numerical parameters used in the specification and claims are approximate values, and the approximation may change according to the characteristics required by the individual embodiments. In some embodiments, the numerical parameter should consider the prescribed effective digits and adopt a general digit retention method. Although in some embodiments, the numerical fields and parameters used to confirm the breadth of its range are approximate values, in specific embodiments, such numerical values are set as accurately as possible within the feasible range.

At last, it should be understood that the embodiments described in the present invention are merely illustrative of the principles of the embodiments of the present invention. Accordingly, embodiments of the present invention are not limited to that precisely as shown and described.

**Claims**

1. A sensor (100) comprising:

    a sensing assembly (110), the sensing assembly including a sensing piezoelectric layer (111) and a sensing electrode layer (112);
    a frequency adjustment assembly (120); the frequency adjustment assembly being physically connected to the sensing assembly, and being deformed under an action of an electrical signal to deform the sensing piezoelectric layer, thereby changing a resonance frequency of the sensing assembly, the frequency adjustment assembly includes a drive electrode layer, wherein a resonance frequency difference of the sensor is not less than 2 kHz, the resonance frequency difference being a difference between a resonance frequency of the sensor when a voltage of the drive electrode layer is 5V and a resonance frequency of the sensor when a voltage of the drive electrode layer is 0V; and
    a substrate (130), the substrate being configured carry the sensing assembly and the frequency adjustment assembly.

2. The sensor of claim 1, wherein the frequency adjustment assembly deforms the sensing piezoelectric layer in a first direction.

3. The sensor of claim 2, wherein the sensing piezoelectric layer is a rectangle and the first direction is in a length direction of the sensing piezoelectric layer.

4. The sensor of claim 3, wherein the sensor is fixedly supported at both ends or peripherally supported.

5. The sensor of claim 2, wherein the sensing piezoelectric layer is a circle and the first direction is in a radial direction of the sensing piezoelectric layer.

6. The sensor of claim 5, wherein the sensor is peripherally supported.

7. The sensor of any one of claims 1-6, wherein the frequency adjustment assembly includes a drive piezoelectric layer (121).

8. The sensor of claim 7, wherein

    the sensing piezoelectric layer and the drive piezoelectric layer are in a same plane,
    the drive piezoelectric layer is in a middle of the sensing piezoelectric layer, a length of the drive piezoelectric layer is in a range of 100%-500% of a length of the sensing piezoelectric layer, and sensing electrodes are distributed within 1/4 of a total length on the sensing piezoelectric layer near a fixedly supported end, the total length is a sum of a length of the sensing piezoelectric layer and a length of the drive piezoelectric layer along a first direction.

9. The sensor of any one of claims 7-8, wherein the voltage of the drive electrode layer drives the drive piezoelectric layer to contract.

10. The sensor of any one of claims 7-9, wherein the sensing piezoelectric layer is connected to the drive electrode layer by a mortise and tenon structure.

11. The sensor of any one of claims 7-10, wherein the sensing piezoelectric layer and the drive piezoelectric layer are an integral structure made of a same material, and the sensing assembly and the frequency adjustment assembly are formed respectively after arranging the sensing electrode layer and the drive electrode layer in different regions on a surface of the integral structure.

12. The sensor of any one of claims 1-11, wherein a deformation of the sensing piezoelectric layer caused by the frequency adjustment assembly is a tensile deformation.

13. The sensor of claim 7, wherein the sensing piezoelectric layer includes at least a first sensing piezoelectric layer (111-1) and a second sensing piezoelectric layer (111-2), and the drive piezoelectric layer is located between the first sensing piezoelectric layer and the second sensing piezoelectric layer.

14. The sensor of claim 13, wherein

the first sensing piezoelectric layer is stacked on the drive piezoelectric layer and the drive piezoelectric layer is stacked on the second sensing piezoelectric layer; or

the first sensing piezoelectric layer, the drive piezoelectric layer, and the second sensing piezoelectric layer are disposed parallel and at intervals from each other, and an end of the first sensing piezoelectric layer, an end of the drive piezoelectric layer, and an end of the second sensing piezoelectric layer are connected by a connection assembly (140).

## Patentansprüche

1.  Sensor (100), umfassend:

    eine Erfassungsbaugruppe (110), wobei die Erfassungsbaugruppe eine piezoelektrische Erfassungsschicht (111) und eine Erfassungselektrodenschicht (112) enthält;
    eine Frequenzeinstellbaugruppe (120);
    wobei die Frequenzeinstellbaugruppe physisch mit der Erfassungsbaugruppe verbunden ist und unter einer Einwirkung eines elektrischen Signals verformt wird, um die piezoelektrische Erfassungsschicht zu verformen, wodurch eine Resonanzfrequenz der Erfassungsbaugruppe geändert wird, die Frequenzeinstellbaugruppe eine Antriebselektrodenschicht enthält, wobei eine Resonanzfrequenzdifferenz des Sensors nicht weniger als 2 kHz beträgt, wobei die Resonanzfrequenzdifferenz eine Differenz zwischen einer Resonanzfrequenz des Sensors, wenn eine Spannung der Antriebselektrodenschicht 5 V beträgt, und einer Resonanzfrequenz des Sensors, wenn eine Spannung der Antriebselektrodenschicht 0 V beträgt, ist; und
    ein Substrat (130), wobei das Substrat dazu konfiguriert ist, die Erfassungsbaugruppe und die Frequenzeinstellbaugruppe zu tragen.

2.  Sensor nach Anspruch 1, wobei die Frequenzeinstellbaugruppe die piezoelektrische Erfassungsschicht in einer ersten Richtung verformt.

3.  Sensor nach Anspruch 2, wobei die piezoelektrische Erfassungsschicht ein Rechteck ist und die erste Richtung in einer Längsrichtung der piezoelektrischen Erfassungsschicht liegt.

4.  Sensor nach Anspruch 3, wobei der Sensor an beiden Enden fest gelagert ist oder peripher gelagert ist.

5.  Sensor nach Anspruch 2, wobei die piezoelektrische Erfassungsschicht ein Kreis ist und die erste Richtung in einer radialen Richtung der piezoelektrischen Erfassungsschicht liegt.

6.  Sensor nach Anspruch 5, wobei der Sensor peripher gelagert ist.

7.  Sensor nach einem der Ansprüche 1-6, wobei die Frequenzeinstellbaugruppe eine piezoelektrische Antriebsschicht (121) enthält.

8.  Sensor nach Anspruch 7, wobei

    die piezoelektrische Erfassungsschicht und die piezoelektrische Antriebsschicht in einer gleichen Ebene liegen,
    die piezoelektrische Antriebsschicht in einer Mitte der piezoelektrischen Erfassungsschicht liegt, eine Länge der piezoelektrischen Antriebsschicht in einem Bereich von 100 % - 500 % einer Länge der piezoelektrischen Erfassungsschicht liegt und
    Erfassungselektroden innerhalb von 1/4 einer Gesamtlänge auf der piezoelektrischen Erfassungsschicht in der Nähe eines fest gelagerten Endes verteilt sind, wobei die Gesamtlänge eine Summe einer Länge der piezoelektrischen Erfassungsschicht und einer Länge der piezoelektrischen Antriebsschicht entlang einer ersten Richtung ist.

9.  Sensor nach einem der Ansprüche 7-8, wobei die Spannung der Antriebselektrodenschicht die piezoelektrische Antriebsschicht so antreibt, dass sie sich zusammenzieht.

10. Sensor nach einem der Ansprüche 7-9, wobei die piezoelektrische Erfassungsschicht durch eine Schlitz- und Zapfenstruktur mit der Antriebselektrodenschicht verbunden ist.

11. Sensor nach einem der Ansprüche 7-10, wobei die piezoelektrische Erfassungsschicht und die piezoelektrische Antriebsschicht eine einstückige Struktur sind, die aus einem gleichen Material hergestellt ist, und die Erfassungsbaugruppe und die Frequenzeinstellbaugruppe jeweils nach dem Anordnen der Erfassungselektrodenschicht und der Antriebselektrodenschicht in unterschiedlichen Bereichen auf einer Oberfläche der einstückigen Struktur ausgebildet sind.

12. Sensor nach einem der Ansprüche 1-11, wobei eine durch die Frequenzeinstellbaugruppe verursachte Verformung der piezoelektrischen Erfassungsschicht eine Zugverformung ist.

13. Sensor nach Anspruch 7, wobei die piezoelektrische Erfassungsschicht mindestens eine erste piezoelektrische Erfassungsschicht (111-1) und eine zweite piezoelektrische Erfassungsschicht (111-2) enthält und sich die piezoelektrische Antriebsschicht zwischen der ersten piezoelektrischen Erfassungsschicht und der zweiten piezoelektrischen Erfassungsschicht befindet.

14. Sensor nach Anspruch 13, wobei

die erste piezoelektrische Erfassungsschicht auf der piezoelektrischen Antriebsschicht gestapelt ist und die piezoelektrische Antriebsschicht auf der zweiten piezoelektrischen Erfassungsschicht gestapelt ist; oder
die erste piezoelektrische Erfassungsschicht, die piezoelektrische Antriebsschicht und die zweite piezoelektrische Erfassungsschicht parallel und in Abständen voneinander positioniert sind und ein Ende der ersten piezoelektrischen Erfassungsschicht, ein Ende der piezoelektrischen Antriebsschicht und ein Ende der zweiten piezoelektrischen Erfassungsschicht durch eine Verbindungsbaugruppe (140) verbunden sind.

**Revendications**

1. Capteur (100) comprenant :

un ensemble de détection (110), l'ensemble de détection comprenant une couche piézoélectrique de détection (111) et une couche d'électrode de détection (112) ;
un ensemble de réglage de fréquence (120) ;
l'ensemble de réglage de fréquence étant physiquement connecté à l'ensemble de détection, et étant déformé sous l'action d'un signal électrique pour déformer la couche piézoélectrique de détection, modifiant ainsi une fréquence de résonance de l'ensemble de détection, l'ensemble de réglage de fréquence comprend une couche d'électrode d'attaque, dans lequel une différence de fréquence de résonance du capteur n'est pas inférieure à 2 kHz, la différence de fréquence de résonance étant une différence entre une fréquence de résonance du capteur lorsqu'une tension de la couche d'électrode d'attaque est de 5 V et une fréquence de résonance du capteur lorsqu'une tension de la couche d'électrode d'attaque est de 0 V ; et
un substrat (130), le substrat étant configuré pour porter l'ensemble de détection et l'ensemble de réglage de fréquence.

2. Capteur selon la revendication 1, dans lequel l'ensemble de réglage de fréquence déforme la couche piézoélectrique de détection dans une première direction.

3. Capteur selon la revendication 2, dans lequel la couche piézoélectrique de détection est un rectangle et la première direction est dans une direction longitudinale de la couche piézoélectrique de détection.

4. Capteur selon la revendication 3, dans lequel le capteur est supporté de manière fixe aux deux extrémités ou supporté de manière périphérique.

5. Capteur selon la revendication 2, dans lequel la couche piézoélectrique de détection est un cercle et la première direction est dans une direction radiale de la couche piézoélectrique de détection.

6. Capteur selon la revendication 5, dans lequel le capteur est supporté de manière périphérique.

7. Capteur selon l'une quelconque des revendications 1 à 6, dans lequel l'ensemble de réglage de fréquence comprend une couche piézoélectrique d'attaque (121).

8. Capteur selon la revendication 7, dans lequel

la couche piézoélectrique de détection et la couche piézoélectrique d'attaque sont sur un même plan,
la couche piézoélectrique d'attaque se trouve au milieu de la couche piézoélectrique de détection,
une longueur de la couche piézoélectrique d'attaque se situe dans une plage de 100 % à 500 % d'une longueur de la couche piézoélectrique de détection, et
les électrodes de détection sont réparties sur un 1/4 d'une longueur totale sur la couche piézoélectrique de détection près d'une extrémité supportée de manière fixe, la longueur totale est une somme d'une longueur de la couche piézoélectrique de détection et d'une longueur de la couche piézoélectrique d'attaque le long d'une première direction.

9. Capteur selon l'une quelconque des revendications 7 à 8, dans lequel la tension de la couche d'électrode d'attaque entraîne la contraction de la couche piézoélectrique d'attaque.

10. Capteur selon l'une quelconque des revendications 7 à 9, dans lequel la couche piézoélectrique de détection est connectée à la couche d'électrode d'attaque par une structure à tenon et mortaise.

11. Capteur selon l'une quelconque des revendications 7 à 10, dans lequel la couche piézoélectrique de détection et la couche piézoélectrique d'attaque sont une structure intégrée faite d'un même matériau, et l'ensemble de détection et l'ensemble de réglage de fréquence sont formés respectivement après avoir agencé la couche d'électrode de détection et la couche d'électrode d'attaque dans des régions différentes sur une surface de la structure intégrée.

12. Capteur selon l'une quelconque des revendications 1 à 11, dans lequel une déformation de la couche piézoélectrique de détection provoquée par l'ensemble de réglage de fréquence est une déformation par traction.

13. Capteur selon la revendication 7, dans lequel la couche piézoélectrique de détection comprend au moins une première couche piézoélectrique de détection (111-1) et une deuxième couche piézoélectrique de détection (111-2), et la couche piézoélectrique d'attaque est située entre la première couche piézoélectrique de détection et la deuxième couche piézoélectrique de détection.

14. Capteur selon la revendication 13, dans lequel

> la première couche piézoélectrique de détection est empilée sur la couche piézoélectrique d'attaque et la couche piézoélectrique d'attaque est empilée sur la deuxième couche piézoélectrique de détection ; ou
> la première couche piézoélectrique de détection, la couche piézoélectrique d'attaque et la deuxième couche piézoélectrique de détection sont disposées en parallèle et à des intervalles les unes des autres, et une extrémité de la première couche piézoélectrique de détection, une extrémité de la couche piézoélectrique d'attaque et une extrémité de la deuxième couche piézoélectrique de détection sont connectées par un ensemble de connexion (140).

**FIG. 1**

100    130    110    120

FIG. 2A

100

121    120    112    122

X'    Y'

a

FIG. 2B

100    120

130

FIG. 2C

FIG. 3A

FIG. 3B

100

120 (121)

111-1

110

111-2

**FIG. 4A**

100

120 (121)

140

111-1

110

111-2

**FIG. 4B**

**FIG. 5**

**FIG. 6**

**EP 4 411 405 B1**

**Patent documents cited in the description**

- US 20150358740 A1

- EP 2109217 A2